(19) Europäisches Patentamt
European Patent Office
Office européen des brevets

(11) Veröffentlichungsnummer: **0 032 575**
**A1**

(12) # EUROPÄISCHE PATENTANMELDUNG

(21) Anmeldenummer: **80108092.0**

(22) Anmeldetag: **20.12.80**

(51) Int. Cl.³: **F 24 J 3/00**, C 25 B 1/04, C 01 B 33/02

(30) Priorität: **19.01.80 DE 3001900**

(43) Veröffentlichungstag der Anmeldung: **29.07.81 Patentblatt 81/30**

(84) Benannte Vertragsstaaten: **BE FR GB IT LU NL**

(71) Anmelder: **Licentia Patent-Verwaltungs-GmbH, Theodor-Stern-Kai 1, D-6000 Frankfurt/Main 70 (DE)**

(72) Erfinder: **Dahlberg, Reinhard, Dr., Innere Bergstrasse 32, D-7101 Flein (DE)**

(74) Vertreter: **Maute, Hans-Jürgen, Dipl.-Ing. et al, Licentia Patentverwaltungs-GmbH Theodor-Stern-Kai 1, D-6000 Frankfurt/Main 70 (DE)**

(54) **Solar-Kraftwerksanlage.**

(57) Die Erfindung betrifft eine Solar-Kraftwerksanlage mit Silizium-Solarzellen (1) als Generatoren, die eine große Fläche bedecken, mit deren Hilfe die Sonneneinstrahlung (2) in elektrische Energie umgewandelt wird. Mit Hilfe der gewonnenen elektrischen Energie wird Wasser in Wasserstoff und Sauerstoff zerlegt. Die Erfindung besteht darin, daß die Kraftwerksanlage zur Herstellung von Silizium herangezogen wird, das wiederum an Ort und Stelle zu Silizium-Solarzellen weiterverarbeitet wird. Dabei wird ein Teil der in der Solar-Kraftwerksanlage erzeugten elektrischen Energie für die zur Gewinnung von Silizium erforderlichen Temperaturprozesse verwendet und ein Teil des durch Elektrolyse erzeugten Wasserstoffs dient der chemischen Verarbeitung des Rohsiliziums zu reinem Silizium bzw. zur Erzeugung der für diese Prozesse erforderlichen elektrischen Energie.

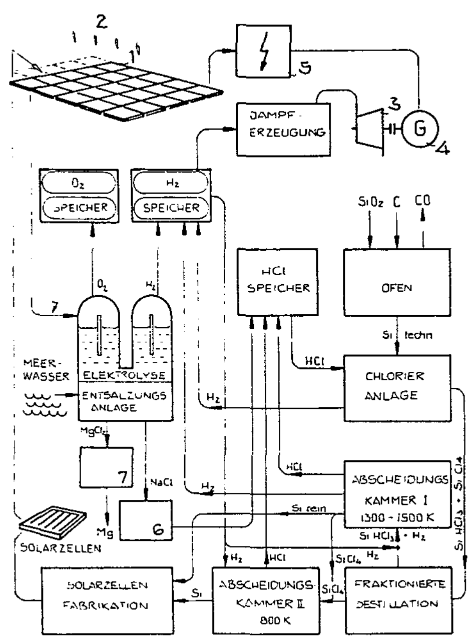


EP 0 032 575 A1

Licentia Patent-Verwaltungs-G.m.b.H
Theodor-Stern-Kai 1, 6000 Frankfurt 70 0032575

Heilbronn, den 20.12.79
SE2-HN-Ma-et - HN 79/58

## Solar-Kraftwerksanlage

Die Erfindung betrifft eine Solar-Kraftwerksanlage aus eine große Fläche bedeckenden Silizium-Solarzellen, mit deren Hilfe die Sonneneinstrahlung in elektrische Energie umgewandelt wird, die ihrerseits zumindest teilweise zur elektrolytischen Zerlegung von Wasser in Wasserstoff und Sauerstoff vorgesehen ist. Eine derartige Anlage wird beispielsweise in der DE-OS 28 10 913 vorgeschlagen.

Es wurden nun Überlegungen angestellt, wie mit Hilfe der Sonnenenergie die Abhängigkeit von den herkömmlichen Energieträgern wie Erdöl, Kohle und Atomkraft reduziert bzw. gänzlich beseitigt werden kann. Ein Hauptproblem besteht dabei darin, daß aus der Sonneneinstrahlung nur dann große Energiemengen gewonnen werden können, wenn große Flächen mit Solarzellen bedeckt werden. Dies bedingt einen enormen technischen und organisatorischen Aufwand, der nur über ein längerfristiges Konzept realisiert werden kann. Der Erfindung liegt daher die Aufgabe zugrunde, eine Solar-Kraftwerksanlage anzugeben, die so konzipiert ist, daß aus der Sonneneinstrahlung eine ständig größer werdende Energiemenge gewonnen werden kann. Die Lösung dieser Aufgabe ergibt sich bei einer Solar-Kraftwerksanlage der eingangs genannten Art durch ihre Verwendung zur Herstellung von reinem, zur Weiterverarbeitung zu Silizium-Solarzellen geeignetem Silizium, wobei zumindest ein Teil der in der Solar-Kraftwerksanlage erzeugten elektrischen Energie für die zur Gewinnung des Siliziums erforderlichen Temperaturprozesse und zumindest ein Teil des elektrolytisch erzeugten Wasserstoffs für die chemische Verarbeitung

des Roh-Siliziums zu reinem Silizium und/oder zur Erzeugung erforderlicher elektrischer Energie dient.

Der Erfindung liegt somit die Konzeption zugrunde, eine Kraftwerksanlage anzugeben, mit deren Hilfe ständig neue Solarzellengeneratoren erzeugt werden und somit eine Erweiterung der Kraftwerksanlage selbst möglich ist. Es handelt sich somit um Kraftwerksanlagen, die mit automatisch arbeitenden Fabriken derart gekoppelt sind, daß die Kraftwerke sich selbst reproduzieren und unter Erhöhung der Leistungskapazität vervielfachen. Dabei muß die Gesamtanlage so ausgelegt sein, daß möglichst viele der erforderlichen Rohstoffe - wie beispielsweise Meerwasser und Quarzsand - am Ort des Kraftwerkes zur Verfügung stehen oder aus den ablaufenden Prozessen als Spalt- oder Zwischenprodukte gewonnen werden können.
Die Solar-Kraftwerksanlage bildet somit mit anderen Einrichtungen und Fabriken ein Kombinat. Dieses Kombinat kann neben dem eigentlichen Kraftwerk eine Fabrik zur Herstellung des Siliziums aufweisen, die wiederum direkt mit einer Fabrik zur Herstellung der Silizium-Solarzellen gekoppelt ist. Schließlich werden auch vorzugsweise am Ort des Kraftwerkes die Solarzellen-Panels zusammengebaut. Mit ihnen wird dann die Kraftwerksanlage kontinuierlich so erweitert, daß die Leistungsabgabe des Kraftwerkes ständig anwächst.

Mit Hilfe der in der Solar-Kraftwerksanlage gewonnenen Energie bzw. des aus dieser Energie gewonnenen Wasserstoffs werden vorzugsweise Silizium-Solarzellen aus nicht einkristallinem Silizium hergestellt.
Die Solar-Kraftwerksanlage weist eine zentrale Stromverteilungsanlage auf, die die zur Herstellung des Siliziums notwendigen Reinigungs- Umsetzungs- und Abscheidungsanlagen sowie die Anlage zur Herstellung der Silizium-Solarzellen kontinuierlich mit Strom versorgt. Diese Stromverteilungsanlage bezieht die abzugebende Leistung entweder direkt über die Solarzellen-Panels und/oder indirekt über Stromgeneratoren, wobei der Generatorantrieb dann durch Verbrennung des elektrolytisch gewonnenen Wasserstoffs bewirkt wird. Auf diese Weise ist ein ununterbrochener Tag- und Nachtbetrieb der Fabriken für die Herstellung des Siliziums bzw. der Solarzellen möglich. Während des Tagbetriebs kann in der Regel die erforderliche elektrische Leistung direkt den Solarzellen-Panels entnommen werden, während im Nachtbetrieb durch Wasserstoffverbrennung Stromgeneratoren angetrieben werden, die die erforderliche Leistung in Zeiten fehlender Sonneneinstrahlung abgeben. Zur Erzeugung des Wasserstoffs dient bei der Sonneneinstrahlung ein Teil der von den Solarzellen-Panels abgegebenen Leistung, die direkt Elektrolyse-Geräten zugeführt wird. In diesen Elektrolysegeräten wird das stets zur Verfügung stehende Wasser in Wasserstoff und Sauerstoff gespalten. Die Solar-Kraftwerksanlage wird daher vorzugsweise in unmittelbarer Nähe größerer Gewässer, insbesondere an Meeresküsten, errichtet werden. Es ist auch denkbar, daß die Gesamtanlage auf einer natürlichen oder künstlichen Meeresinsel untergebracht wird.

Die für die Herstellung des Siliziums notwendigen Reinigungs-, Umsetzungs- und Abscheidungsanlagen werden so miteinander verknüpft, daß Spalt- oder Zwischenprodukte - wie Wasserstoff, Salzsäure, Chlor - im Produktionsablauf des Siliziums wieder verwendet oder Speichern zugeführt werden. Die Anlagen sind dabei so ausgelegt, daß möglichst viele der benötigten Hilfsstoffe und Rohstoffe aus Meerwasser gewonnen werden können.

So können auch die Reduktionsmittel, mit deren Hilfe Siliziumdioxyd bzw. Quarz in Silizium umgewandelt werden, aus Meerwasser gewonnen werden. Ein Beispiel dafür ist das Reduktionsmittel Magnesium, das aus im Meerwasser stets vorhandenem Magnesiumchlorid gewonnen wird. Meerwasser enthält im Mittel etwa 3,8 kg $MgCl_2$ pro Tonne. Ein weiteres Beispiel ist Natrium, welches über Schmelzelektrolyse von NaCl gewonnen werden kann. In einer Tonne Meerwasser sind etwa 27 kg NaCl enthalten.

Zur Herstellung und Reinigung von Silizium wird bei den meisten Prozessen Salzsäure oder Chlor benötigt. Auch diese Stoffe lassen sich leicht aus den im Meerwasser enthaltenen Salzen gewinnen oder entstehen als Spalt- oder Zwischenprodukte bei der Produktion des Siliziums in wiederverwendbarer Weise. Daraus ergibt sich, daß für diese Spalt- und Zwischenprodukte ebenso wie für Wasserstoff und Sauerstoff Speicherbehälter oder Zwischenspeicher vorgesehen sein müssen. In diesen Speichern können die genannten Produkte in gasförmiger, flüssiger oder gebundener fester Form gelagert werden.

Die Solar-Kraftwerksanlage sowie die mit ihr verbundenen Fabrikationsanlagen zur Herstellung des Siliziums und der Silizium-Solarzellen werden vorzugsweise über eine zentrale, automatisch arbeitende Steueranlage geregelt. Hierzu sind eine Fülle von Sensoren und Sensorleitungen notwendig, die der Steueranlage alle extern zugänglichen Informationen wie Temperaturen, Stoffdurchsatz, Gasmengen, Gasgeschwindigkeiten, Materialzusammensetzungen u. dgl. innerhalb der Anlage zuführen. Von der zentralen Steueranlage gehen dann Regelkreise aus, durch die in Abhängigkeit von den extern zugeführten Informationen programmgesteuert optimale Verhältnisse eingestellt werden. Die zentrale Steueranlage ist im Hinblick auf die Vielfalt der notwendigen Kontroll- und Optimierungsprozesse mit einer Großrechenanlage verbunden.

Die Erfindung und ihre weitere vorteilhafte Ausgestaltung soll noch an Hand von zwei Ausführungsbeispielen näher erleutert werden.
Hierzu zeigen die Fig. 1 und 2 Ablaufdiagramme mit den wichtigsten Prozeßschritten. Aus diesen Diagrammen wird besonders deutlich, wie im Produktionsablauf anfallende Spalt- und Zwischenprodukte wieder verwendet werden können. Der Übersichtlichkeit halber wurde die Stromversorgung aller Anlagen nicht dargestellt. Es ist jedoch selbstverständlich, daß alle Anlagen und Geräte über die zentrale Stromverteilungsanlage die benötigte Energie erhalten, wobei die Stromverteilungsanlage ihrerseits die Energie aus unterschiedlichen Quellen beziehen kann.

In der Fig. 1 ist ein Silizium-Solarzellen-Panel 1 einer Solar-Kraftwerksanlage angedeutet. Diese Solarzellen-Panels bedecken große Flächen, beispielsweise viele Quadratkilometer in einem nicht oder nur wenig besiedelten Gebiet. In diesem Gebiet soll zumindest Meerwasser und Quarz zur Verfügung stehen. Bei dem dargestellten Ausführungsbeispiel ist es auch von Vorteil, wenn Kohle im Bereich der Kraftwerksanlage abgebaut oder zugeführt werden kann.

Gemäß Fig. 1 wird die bei Sonneneinstrahlung erzeugte elektrische Leistung teilweise an eine Stromverteilungsanlage 5 abgegeben. Ein anderer Teil der durch die Solarzellen-Panels erzeugten elektrischen Leistung wird direkt den Elektrolysegeräten zugeführt, in denen das am Ort vorhandene Meerwasser in Sauerstoff und Wasserstoff aufgespalten wird. Gemäß der Darstellung wird der Sauerstoff einerseits und der Wasserstoff andererseits Speicherbehältern in gasförmiger oder flüssiger Form zugeführt. Durch die Zersetzung des Meerwassers fällt eine in der Konzentration ständig zunehmende Solelösung an, die sich zu Salzen und anderen Spaltprodukten weiterverarbeiten läßt. Dadurch entfällt die Notwendigkeit, eine gesonderte Entsalzungsanlage zu errichten. Andererseits besteht jedoch die Möglichkeit - wie in der Fig. 1 angedeutet -, eine gesonderte Entsalzungsanlage zu errichten und dem Elektrolysegerät selbst bereits salzfreies Wasser zuzuführen. Aus der Entsalzungsanlage können beispielsweise die Stoffe Magnesiumchlorid und Natriumchlorid ausgesondert und weiterverarbeitet werden. Aus Magnesiumchlorid läßt sich Magnesium und Chlor herstellen, während - falls erforderlich - aus Natriumchlorid Salzsäure gewonnen und einem gesonderten Salzsäurespeicher zugeführt werden kann. Es läßt sich aber erfindungsgemäß auch aus Natriumchlorid über Schmelzelektrolyse Natrium-Metall und Chlor gewinnen. Mit Hilfe einer Reaktion von Natrium mit

$SiO_2$ kann man $Na_2Si$ erzeugen. Druch thermische Zersetzung im Vakuum entsteht daraus Silizium und Natrium.

Bei dem dargestellten Ausführungsbeispiel soll Quarz bzw. Siliziumdioxyd mit Hilfe von zur Verfügung stehendem Kohlenstoff als Reduktionsmittel zu technischem Silizium und Kohlenmonoxyd (CO) umgewandelt werden. Dies erfolgt nach der chemischen Gleichung

$$SiO_2 + 2\ C \rightarrow Si + 2\ CO$$

Diese Reaktion läuft bei ca. 1460 °C ab. Dieses technische Silizium wird nach dem sogenannten Trichlorsilanverfahren zu reinem Silizium weiterverarbeitet. Trichlorsilan entsteht durch Chlorierung von technisch reinem Silizium durch trockenes, aktiviertes Salzsäuregas bei 200 - 400 °C nach der Reaktion

$$Si + 3\ HCl \rightarrow 2\ SiHCl_3 + H_2.$$

Die erforderliche Salzsäure wird gemäß dem Ausführungsbeispiel nach Fig. 1 dem HCl-Speicher entnommen. Der in der Chlorieranlage freiwerdende Wasserstoff wird wiederum dem Wasserstoffspeicher zugeführt. Neben dem Trichlorsilan entsteht in der Chlorieranlage auch eine größere Menge Siliziumtetrachlorid ($SiCl_4$). Das aus der Chlorieranlage freiwerdende Gemisch aus Siliziumtetrachlorid und Trichlorsilan wird in einer Anlage durch fraktionierte Destillation in seine Bestandteile aufgeteilt. Nun müssen die Siliziumverbindungen noch durch thermische Dissoziation unter gleichzeitiger Reduktion mit Wasserstoff bei einer möglichst niedrigen Temperatur zersetzt werden.

Das Trichlorsilan wird beispielsweise mit gereinigtem Wasserstoff, der dem Wasserstoffspeicher entnommen wird, im Verhältnis von etwa 1 : 10 verdünnt und gelangt in die Abscheidungskammer I. An glühenden Unterlagen, beispielsweise aus Kohlenstoff, erfolgt die Reduktion

und Dissoziation des Trichlorsilans nach folgender Gleichung:

$$4\ SiHCl_3 \longrightarrow Si + 3\ SiCl_4 + 2\ H_2$$

$$SiHCl_3 + H_2 \longrightarrow Si + 3\ HCl$$

Das Silizium setzt sich mikrokristallin an den Unterlagen ab. Die Zersetzungsprodukte HCl, $SiCl_4$ und $H_2$ werden voneinander getrennt. Die Salzsäure HCl wird dem Salzsäurespeicher zugeführt; der Wasserstoff gelangt wiederum in den Wasserstoffspeicher und das Siliziumtetrachlorid ($SiCl_4$) wird der Abscheidungskammer II zugeführt, der auch das Siliziumtetrachlorid aus der fraktionierten Destillationsanlage zugeleitet wird. Die Abscheidungstemperatur in der Kammer I liegt bei ca. 1300 - 1500 °K.

In der Abscheidungskammer II erfolgt die Zersetzung des Siliziumtetrachlorids bei ca. 1800 °K in Silizium und Salzsäure gemäß folgender chemischen Gleichung:

$$SiCl_4 + 2\ H_2 \longrightarrow Si + 4\ HCl.$$

Die freiwerdende Salzsäure wird wiederum dem Salzsäurespeicher zugeführt. Der notwendige Wasserstoff wird dem Wasserstoffspeicher entnommen.

Somit wird sowohl in der Abscheidungskammer I als auch in der Abscheidungskammer II äußerst reines mikrokristallines Silizium gewonnen, das in einer angeschlossenen Solarzellenfabrik gemäß den bekannten und üblichen Technologien zu Silizium-Solarzellen weiterverarbeitet wird. Die einzelnen Solarzellen werden, wie dies in der Fig. 1 angedeutet ist, zu Solarzellen-Panels weiterverarbeitet, mit denen die Sonnenlicht 2 zu elektrischer Energie umwandelnde Generatorfläche erweitert wird.

Für die genannten Prozesse muß erhebliche elektrische Energie aufgewendet werden. Diese elektrische Energie wird jeweils der Stromverteilungsanlage 5 entnommen, die entweder direkt aus den Solarzellen-Panels gespeist wird oder die

ihre elektrische Leistung aus einem Generator 4 bezieht, der von einer Turbine 3 angetrieben wird. Der Turbinenantrieb erfolgt beispielsweise mittels Wasserdampf, der durch die Verbrennung von Wasserstoff erzeugt wird. Dieser Wasserstoff wird dem Wasserstoffspeicher entnommen. Der Generator 4 wird nur dann zur Stromabgabe verwendet, wenn die von den Solarzellen-Panels gelieferte elektrische Leistung nicht zum Betrieb der angeschlossenen Anlagen ausreicht. In diesem Fall sorgt eine zentrale Steueranlage für die Belastung des Generators und für die notwendige Wasserstoffverbrennung. Die an das Kraftwerk angeschlossenen Anlagen können somit im Tag- und Nachtbetrieb gefahren werden, wobei tagsüber die elektrische Leistung direkt aus den Solarzellen-Panels stammt und nachts die gleichfalls während des Tages erzeugte Wasserstoffmenge wenigstens teilweise verbrannt wird. Anstelle einer konventionellen Dampfturbine zur Erzeugung von elektrischer Energie, kann der bei der Wasser-Elektrolyse erzeugte sehr reine Wasserstoff und Sauerstoff vorzugsweise auch in einem Fuel-Cell-Kraftwerk durch eine katalytische "kalte Verbrennung" direkt zur Erzeugung elektrischer Energie herangezogen werden.

In der Fig. 1 wurde bereits angedeutet, daß aus Meerwasser Magnesium als Reduktionsmittel gewonnen werden kann. An Hand der Fig. 2 soll näher dargelegt werden, wie mit Hilfe dieses Magnesiums technisches Silizium gewonnen werden kann.

In der Fig. 2 ist wiederum ein Solarzellen-Panel 1 dargestellt, durch das bei Sonneneinstrahlung 2 elektrische Leistung erzeugt wird. Diese elektrische Leistung wird wiederum zur Elektrolyse von Meerwasser verwendet, um Wasserstoff und Sauerstoff zu gewinnen. Aus der zurückbleibenden Solelösung des Elektrolysegerätes oder aus einer gesonderten Trennanlage wird Salz (NaCl) und Magnesiumchlorid ($MgCl_2$) gewonnen. In der Anlage 6 wird NaCl zu Salzsäure verarbeitet, während das $MgCl_2$ durch

Schmelzelektrolyse in Magnesium und Chlor verwandelt wird. Dies geschieht bei ca. 700 -750 °C nach folgender Gleichung:

$$MgCl_2 \rightarrow Mg + Cl_2.$$

Das Spaltprodukt Chlor kann in der Chlorieranlage weiter verwendet werden.

Das gewonnene Magnesium wird zusammen mit Quarz ($SiO_2$) in ein Gemisch aus Silizium und Magnesiumoxid gemäß folgender Beziehung verwandelt:

$$MgO + SiO_2 + 2\ Mg = (Si + 3\ MgO).$$

Diese Reaktion läuft mit MgO-Pufferung bei Rotglut ab. Das Reaktions-Gemisch aus Silizium und Magnesiumoxid wird einer Chlorieranlage zugeführt, der auch das Chlorgas aus der Schmelzelektrolyse zugeleitet wird. Dabei läuft bei ca. 300 - 310 °C folgende Reaktion ab:

$$Si + 3\ MgO + 2\ Cl_2 = SiCl_4 + 3\ MgO.$$

Das freiwerdende Magnesiumoxid kann wieder dem Ofen zugeführt und dort mit dem Silizium verbunden werden. Das Siliziumtetrachlorid wird nach einer nicht näher dargestellten fraktionierten Destillation in eine Abscheidungsanlage, wie sie bereits an Hand der Fig. 1 beschrieben wurde, eingelassen. Dieser Abscheidungsanlage wird ferner aus dem Wasserstoffspeicher Wasserstoff zugeführt. In der Abscheidungsanlage läuft bei ca. 1500 °C folgende Reaktion ab:

$$SiCl_4 + 2\ H_2 = Si + 4\ HCl.$$

Die gewonnene Salzsäure (HCl) wird dem HCl-Speicher zugeführt, dem sie wieder für alle erforderlichen Reinigungsprozesse entnommen werden kann. Das reine Silizium, das in der Abscheidungsanlage gewonnen wurde, geht wiederum zur Weiterverarbeitung in die Solarzellenfabrik, die zur Erweiterung der Kraftwerksanlage neue Solarzellen-Panels erzeugt.
Die Stromversorgung entspricht bei einer Anlage gemäß der Fig. 2 jener, die bereits an Hand der Fig. 1 beschrieben wurde. In den Schemaablauf ist anstelle einer herkömmlichen Turbin die bereits beschriebene Fuel-Cell-Anlage eingearbeitet. Auch hier ist die Stromverteilungsanlage 5 so ausgelegt, daß sie entweder direkt Strom aus den Solarzellen-Panels oder aus der mit Wasserstoff betriebenen Generatoranlage zur Aufrechterhaltung eines kontinuierlichen Tag- und Nachtprozesses erhält.

Es besteht auch die Möglichkeit, das aus Meerwasser gewonnene Magnesium mit Quarz zu Magnesiumsilizid umzusetzen. Aus Magnesiumsilizid läßt sich dann Monosilan gewinnen. Dafür gilt folgende Gleichung:

$$Mg_2Si + 4\ HCl \longrightarrow 2\ MgCl_2 + SiH_4.$$

Zwischen 400 und 500 °C dissoziiert das Monosilan zu Silizium und Wasserstoff, wobei dieser Wasserstoff wiederum dem Wasserstoffspeicher zur Weiterverwendung zugeleitet wird.

An Hand der Ausführungsbeispiele wurde dargelegt, wie eine Solar-Kraftwerksanlage aussehen kann, die sich mit Hilfe der aus Sonnenenergie gewonnenen elektrischen Energie reproduzieren und vervielfachen kann. Dabei werden so weitgehend wie möglich nur Rohstoffe verwendet, die am Ort der Solar-Kraftwerksanlage zur Verfügung stehen. Dies ist für Siliziumdioxyd praktisch immer der Fall, da es sich hierbei um den am meisten

auf der Erde vorkommenden Rohstoff handelt. Auch die Salze des Meerwassers und Meerwasser selbst werden bei geeigneter Stationierung der Anlage in Gebieten großer Sonneneinstrahlung und geringer Bevölkerungsdichte immer zur Verfügung stehen. Mit Hilfe dieser Anlage kann sich eine Kraftwerksanlage im Laufe mehrerer Jahre ständig vergrößern, so daß eine immer kostengünstigere und umfangreichere Produktion von Energie möglich wird. Im Laufe der Zeit werden immer größere Mengen von Wasserstoff als Überschuß anfallen, der dann als Primärenergie anstelle von Erdöl oder Kohle weiter verwendet wird. Dieser Wasserstoff kann gasförmig unter Druck mittels Pipelines über große Strecken transportiert werden.
Es kann ferner chemisch gebunden z. B. als Hydrazin oder auch als Metall-Hydrid oder aber auch tiefgekühlt in flüssiger Form an Orte des Bedarfs in der Welt transportiert werden.

Licentia Patent-Verwaltungs-G.m.b.H
Theodor-Stern-Kai 1, 6000 Frankfurt 70

0032575

Heilbronn, den 20.12.79
SE2-HN-Ma-et - HN 79/58

## Patentansprüche

1) Solar-Kraftwerksanlage aus eine große Fläche bedeckenden Silizium-Solarzellen, mit deren Hilfe die Sonneneinstrahlung in elektrische Energie umgewandelt wird, die ihrerseits zumindest teilweise zur elektrolytischen Zerlegung von Wasser in Wasserstoff und Sauerstoff vorgesehen ist, gekennzeichnet durch ihre Verwendung zur Herstellung von reinem, zur Weiterverarbeitung zu Silizium-Solarzellen geeignetem Silizium, wobei zumindest ein Teil der in der Solar-Kraftwerksanlage erzeugten elektrischen Energie für die zur Gewinnung des Siliziums erforderlichen Temperaturprozesse und zumindest ein Teil des elektrolytisch erzeugten Wasserstoffes für die chemische Verarbeitung des Rohsiliziums zu reinem Silizium und/oder zur Erzeugung erforderlicher elektrischer Energie dient.

2) Solar-Kraftwerksanlage nach Anspruch 1, dadurch gekennzeichnet, daß mit Hilfe der gewonnenen elektrischen Energie, des erzeugten Wasserstoffs und des erzeugten Siliziums, Silizium-Solarzellen hergestellt werden, die unmittelbar zur Erweiterung der vorhandenen Solar-Kraftwerksanlage dienen.

3) Solar-Kraftwerksanlage nach Anspruch 1 oder 2, gekennzeichnet durch die Kombination mit für die Herstellung von Silizium geeigneten Reinigungs-, Umsetzungs- und Abscheidungsanlagen, die miteinander so verknüpft sind, daß Spalt- oder Zwischenprodukte - wie Wasserstoff, Salzsäure, Chlor - im Produktionsablauf des Siliziums wieder verwendet oder

Speichern zugeführt werden.

4) Solar-Kraftwerksanlage nach Anspruch 3, dadurch gekennzeichnet, daß die Reinigungs-, Umsetzungs- und Abscheidungsanlagen so ausgelegt sind, daß möglichst viele der benötigten Hilfsstoffe aus Meerwasser und Sand gewonnen oder dem Produktionsablauf in Form von Spalt- oder Zwischenprodukten entnommen werden können.

5) Solar-Kraftwerksanlage nach einem der vorangehenden Ansprüche, dadurch gekennzeichnet, daß eine zentrale Stromverteilungsanlage vorgesehen ist, die die Reinigungs-, Umsetzungs- und Abscheidungsanlagen sowie die Anlage zur Herstellung von Silizium-Solarzellen mit Strom kontinuierlich versorgt und daß die Speisung dieser Stromverteilungsanlage direkt über die Solarzellen und/oder indirekt über Stromgeneratoren erfolgt, wobei der Generatorantrieb durch Verbrennung des elektrolytisch gewonnenen Wasserstoffs bewirkt wird.

6) Verfahren zum Betrieb einer mit der Silizium- und Solarzellen-Herstellung kombinierten Solar-Kraftwerksanlage nach einem der vorangehenden Ansprüche, dadurch gekennzeichnet, daß das Reduktionsmittel zur Erzeugung von Rohsilizium aus Siliziumdioxyd aus dem Meerwasser gewonnen wird.

7) Verfahren nach Anspruch 6, dadurch gekennzeichnet, daß als Reduktionsmittel Magnesium aus dem im Meerwasser enthaltenen Magnesiumchlorid gewonnen wird.

8) Verfahren nach Anspruch 6 dadurch gekennzeichnet, daß als Reduktionsmittel Natrium aus dem im Meerwasser enthaltenen Natriumchlorid gewonnen wird.

9) Verfahren nach einem der vorangehenden Ansprüche, dadurch gekennzeichnet, daß die bei der Reinigung, Umsetzung und Abscheidung von Silizium bzw. Silizium enthaltenden Zwischenprodukten benötigten Stoffe - wie Salzsäure und Chlor - aus den im Meerwasser enthaltenen Salzen gewonnen werden.

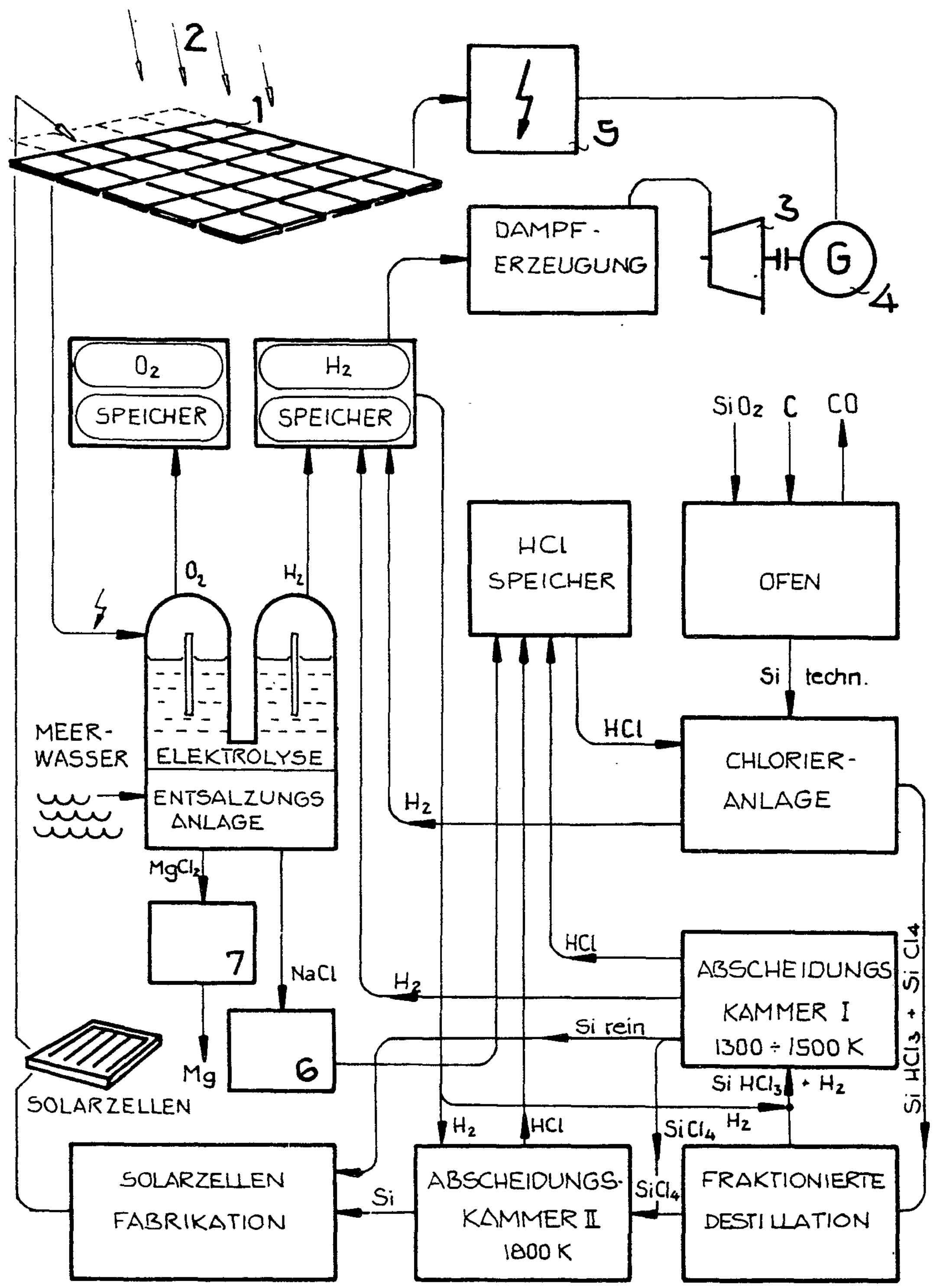
2
1
5
DAMPF-
ERZEUGUNG
3
G
4
$O_2$
SPEICHER
$H_2$
SPEICHER
$SiO_2$ C CO
HCl
SPEICHER
OFEN
Si techn.
$O_2$
$H_2$
MEER-
WASSER
ELEKTROLYSE
ENTSALZUNGS
ANLAGE
HCl
CHLORIER-
ANLAGE
$H_2$
$MgCl_2$
7
NaCl
HCl
$H_2$
ABSCHEIDUNGS
KAMMER I
1300 ÷ 1500 K
$Si HCl_3 + Si Cl_4$
Si rein
Mg
6
$Si HCl_3 + H_2$
SOLARZELLEN
$H_2$
HCl
$SiCl_4$
$H_2$
SOLARZELLEN
FABRIKATION
Si
ABSCHEIDUNGS-
KAMMER II
1800 K
$SiCl_4$
FRAKTIONIERTE
DESTILLATION

Fig. 1

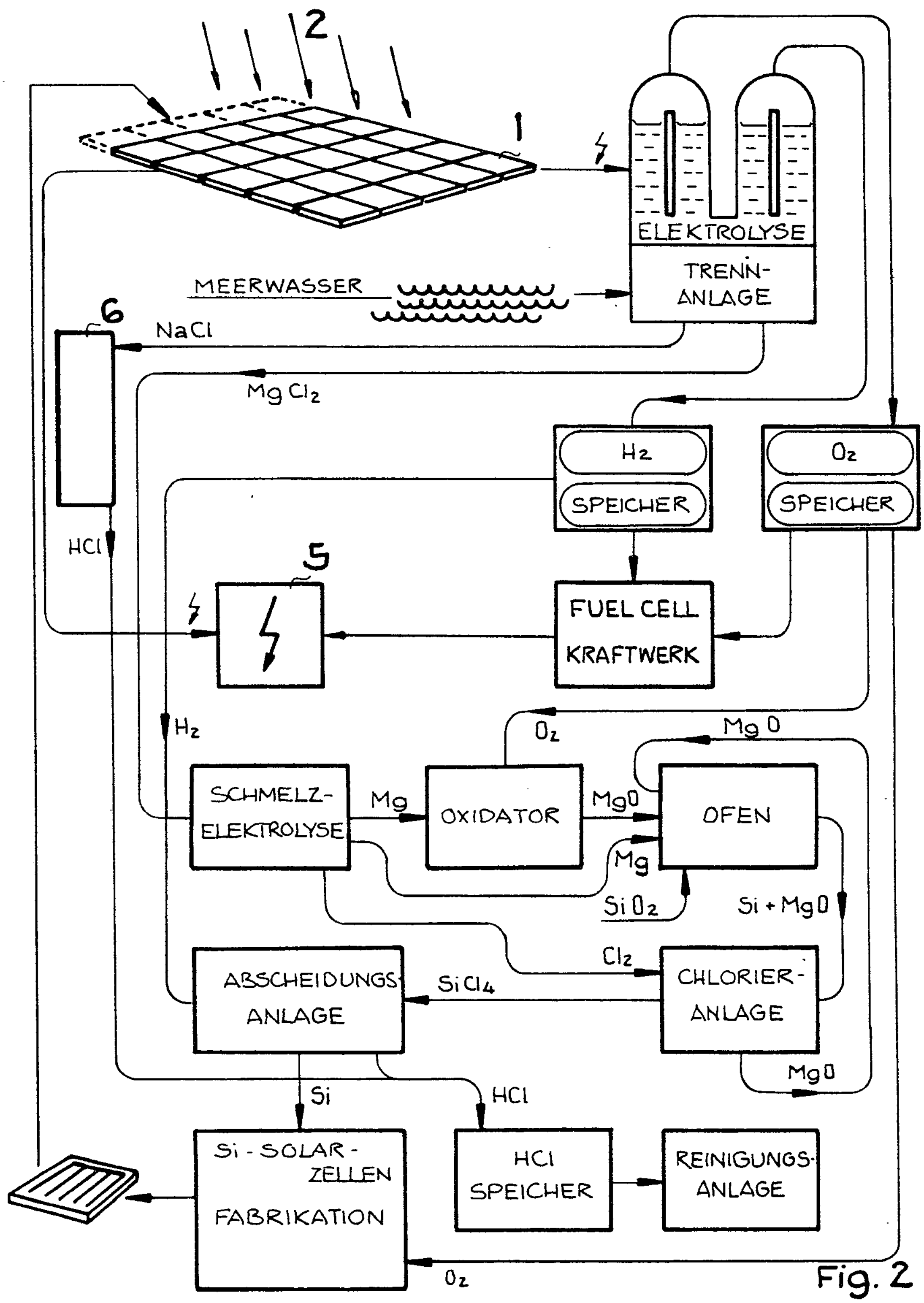
2
1
ELEKTROLYSE
TRENN-
ANLAGE
MEERWASSER
6
NaCl
Mg Cl2
H2
SPEICHER
O2
SPEICHER
HCl
5
FUEL CELL
KRAFTWERK
H2
O2
Mg O
SCHMELZ-
ELEKTROLYSE
Mg
OXIDATOR
MgO
OFEN
Mg
Si O2
Si + MgO
Cl2
ABSCHEIDUNGS
ANLAGE
Si Cl4
CHLORIER-
ANLAGE
MgO
Si
HCl
Si - SOLAR -
ZELLEN
FABRIKATION
HCl
SPEICHER
REINIGUNGS-
ANLAGE
O2

Fig. 2

Europäisches Patentamt

# EUROPÄISCHER RECHERCHENBERICHT

0032575

Nummer der Anmeldung

EP 80 10 8092.0

| EINSCHLÄGIGE DOKUMENTE | | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | EP - A1 - 0 004 565 (LICENTIA PATENT-VERWALTUNGS-GMBH)<br>* Seite 9, Zeilen 19 bis 35; Fig. 1, 2 *<br>-- | 1,4,5 | F 24 J 3/00<br>C 25 B 1/04<br>C 01 B 33/02 |
| | FR - A1 - 2 300 979 (SAUVANET)<br>* Fig. 1, 2 *<br>-- | 1,5 | |
| | DE - A1 - 2 653 649 (KRAFTWERK UNION)<br>* ganzes Dokument *<br>-- | 7-9 | RECHERCHIERTE SACHGEBIETE (Int. Cl.³) |
| | DE - A1 - 2 800 254 (WESTINGHOUSE ELECTRIC CORP.)<br>* Seite 5, Absatz 4 bis Seite 6, Absatz 3 *<br>-- | 7-9 | C 01 B 33/00<br>C 02 F 1/00<br>C 25 B 1/00<br>F 03 G 7/02<br>F 24 J 3/00 |
| A | US - A - 4 161 657 (SHAFFER, JR.)<br>* Fig. 1 *<br>---- | 1 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 08-04-1981 | PIEPER |

EPA form 1503.1 06.78